Europäisches Patentamt

European Patent Office

Office européen des brevets

(19)

(11) Veröffentlichungsnummer: **0 361 194**
**A2**

(12) # EUROPÄISCHE PATENTANMELDUNG

(21) Anmeldenummer: 89116803.1

(22) Anmeldetag: 11.09.89

(51) Int. Cl.⁵ **B29C 45/14 , B29C 45/16 , H01L 21/56**

(30) Priorität: 30.09.88 DE 3833276

(43) Veröffentlichungstag der Anmeldung:
04.04.90 Patentblatt 90/14

(84) Benannte Vertragsstaaten:
**AT BE CH DE FR GB IT LI NL SE**

(71) Anmelder: **Siemens Aktiengesellschaft**
**Wittelsbacherplatz 2**
**D-8000 München 2(DE)**

(72) Erfinder: **Rauchmaul, Siegfried**
**Konrad-Celtis-Strasse 70**
**D-8000 München 70(DE)**
Erfinder: **Schmidt, Hans-Fr., Dr.**
**Graf-Tattenbachweg 3b**
**D-8191 Eurasburg(DE)**
Erfinder: **Criens, Ralf, Dr.**
**Stengelstrasse 2**
**D-8000 München 40(DE)**

(54) Verfahren zum Umhüllen von elektrischen oder elektronischen Bauelementen oder Baugruppen und Umhüllung für elektrische oder elektronische Bauelemente oder Baugruppen.

(57) Zum Umhüllen von Bauelementen oder Baugruppen werden zunächst auf die mechanisch empfindlichen Bereiche eine elastische Zwischenschicht (Z1) und dann in der Hohlform (H12) eines Spritzgießwerkzeugs (W12) durch Spritzgießen einer Formmasse eine mechanisch und chemisch stabile äußere Umhüllungsschicht (U1) aufgebracht. Da es sich beim Spritzgießen um ein leicht automatisierbares und wirtschaftliches Verfahren handelt, wird die Zwischenschicht (Z1) vorzugsweise ebenfalls durch Spritzgießen in einer Hohlform aufgebracht.

**FIG 3**

EP 0 361 194 A2

# Verfahren zum Umhüllen von elektrischen oder elektronischen Bauelementen oder Baugruppen und Umhüllung für elektrische und elektronische Bauelemente oder Baugruppen

Die Erfindung betrifft ein Verfahren zum Umhüllen von elektrischen und elektronischen Bauelementen oder Baugruppen, bei welchem zunächst auf die mechanisch empfindlichen Bereiche eine Zwischenschicht aus einem elastischen Kunststoff und dann eine äußere Umhüllungsschicht aus einem mechanisch und chemisch stabilen Kunststoff aufgebracht werden, sowie eine Umhüllung für elektrische und elektronische Bauelemente oder Baugruppen mit einer auf die mechanisch empfindlichen Bereiche aufgebrachten Zwischenschicht aus einem elastischen Kunststoff und einer äußeren Umhüllungsschicht aus einem mechanisch und chemisch stabilen Kunststoff.

Es ist bekannt, daß duroplastisch umhüllte elektronische Bauelemente, wie z.B. integrierte Schaltungen, oder Baugruppen, wie z.B. Hybridschaltungen, durch innere Spannungen bzw. durch Korrosion zerstört werden. Die inneren Spannungen werden durch Kunststoff-Schwindung sowie durch unterschiedliche thermische Dehnungen von Bauelement bzw. Baugruppe, Systemträger und Kunststoff erzeugt. Es wird daher eine Umhüllung gefordert, die sowohl die Spannungen und die unterschiedlichen Dehnungen kompensiert als auch Schutz gegen innere Korrosion bietet. Je nach Bauform werden derzeit z.B. integrierte Schaltkreise vor der duroplastischen Umhüllung kostenintensiv mit einer Schutzschicht abgedeckt, die beispielsweise aus Plasmanitrid, Polyimid und oder Gel-Tropfen besteht. Dabei bleiben die Bereiche außerhalb des Chips wie z.B. der Chip-Umfang und die Kontaktstelle Bonddraht Anschlußbein ungeschützt. Beim Umhüllen von Baugruppen wird eine elastische Zwischenschicht zum Schutz der Bauelemente und der Schaltung angewandt, die beispielsweise aus Silikongel oder aus einem elastischen Acrylat besteht.

Aus der DE-A-34 42 131 ist ein Verfahren zum Umhüllen von mikroelektronischen Hybrid-Halbleiterschaltungen oder von mikroelektronischen Halbleiterbauelementen bekannt, bei welchem die auf einem Substrat befindlichen Bauelemente mit einer weichen, siegelfähigen Kunststoffschicht übergossen, mit einer Kunststoff-Metall-Verbundfolie abgedeckt und anschließend mit Kunstharz verkapselt werden. Bei diesem relativ aufwendigen Verfahren wird als weiche, siegelfähige Kunststoffschicht beispielsweise ein niederviskoses, flüssiges Elastomer aufgebracht. Auf diese Schicht wird dann eine Kunststoff-Metall-Verbundfolie aufgelegt und mit einem erhitzten Hohlstempel angepreßt. Für das anschließende Vergießen bzw. Verkapseln wird dann ein Kunstharz, insbesondere ein hochgefülltes Epoxidharz verwendet.

In der älteren europäischen Patentanmeldung Nr. 88 11 3887.9 wird eine spannungsarme Umhüllung für elektrische und elektronische Bauelemente, insbesondere Hybridschaltungen vorgeschlagen, bei welcher zunächst auf die mechanisch empfindlichen Bereiche eine elastische und kompressible Zwischenschicht und dann eine mechanisch und chemisch stabile äußere Umhüllungsschicht aufgebracht werden. Zur Erzeugung der elastischen und gleichzeitig kompressiblen Eigenschaft der Zwischenschicht wird beispielsweise ein Zweikomponente-Polyurethan aufdosiert, bei welchem es durch die Anwesenheit geringer Mengen Wasser zu einer Blasenbildung kommt. Gemäß einer anderen Ausführungsform wird für die Zwischenschicht ein UV-härtender Silikonkautschuk verwendet, in welchen Mikrohohlkörper aus Polyvinylidenchlorid (PVDC) eingemischt sind. In beiden Fällen erfolgt dann das Aufbringen der äußeren Umhüllungsschicht durch vergießen mit einem Reaktionsharz auf Epoxid- oder Phenolharzbasis.

Der Erfindung liegt die Aufgabe zugrunde, ein wirtschaftliches und leicht automatisierbares verfahren zum Umhüllen von elektrischen oder elektronischen Bauelementen oder Baugruppen zu schaffen, das eine Kompensation von Spannungen und unterschiedlichen Dehnungen ermöglicht und auch einen sicheren Schutz gegen innere Korrosion bietet. Ferner soll eine den genannten An forderungen genügende Umhüllung angegeben werden.

Diese Aufgabe wird bei einem gattungsgemäßen Verfahren erfindungsgemäß dadurch gelöst, daß die äußere Umhüllungsschicht in der Hohlform eines Spritzgießwerkzeugs durch Spritzgießen einer Formmasse aufgebracht wird.

Der Erfindung liegt die Erkenntnis zugrunde, daß durch die Vorteile einer elastischen Zwischenschicht für das Aufbringen der äußeren Umhüllungsschicht das besonders wirtschaftliche Spritzgießen angewandt werden kann. Das Spritzgießen ist hierbei als ein Urformen anzusehen, das bei Ausnutzung maschinenund werkzeugtechnischer Gegebenheiten in einem einzigen, von der Maschine vollzogenen Arbeitsschritt von der Formmasse zur fertigen äußeren Umhüllungsschicht führt. Die Vorteile gegenüber dem bisher üblichen Vergießen mittels Kunstharz liegen in der wirtschaftlichen und leicht automatisierbaren Arbeitsweise, bei welcher die Notwendigkeit des Dosierens entfällt, dem geringen Abfall, sowie in der praktisch unbegrenzten Lagerfähigkeit des verwendeten Materials. Ein Reaktionsschwund tritt dabei nicht auf, d.h. die Schwindung wird nur durch thermische Dehnungen verursacht.

Gemäß einer bevorzugten Ausgestaltung der Erfindung wird für die äußere Umhüllungsschicht eine thermoplastische Formmasse verwendet, die durch ihre Thermoplastizität für eine Verarbeitung durch Spritzgießen besonders gut geeignet ist. Im Hinblick auf die geforderte mechanische und chemische Stabilität der äußeren Umhüllungsschicht haben sich hierbei teilkristalline und insbesondere auch flüssigkristalline Thermoplaste als Formmassen besonders gut bewährt.

Gemäß einer besonders bevorzugten Ausgestaltung der Erfindung ist vorgesehen, daß die Zwischenschicht in der Hohlform eines ersten Spritzgießwerkzeugs durch Spritzgießen einer Formmasse aufgebracht wird. Somit werden auch für die Herstellung der Zwischenschicht die zuvor beschriebenen Vorteile des Spritzgießens realisiert. Als Formmasse für die Zwischenschicht sind dabei im Hinblick auf die geforderte Elastizität thermoplastische Elastomere besonders gut geeignet, da sie durch Spritzgießen problemlos verarbeitet werden können. Weitere Vorteile bringt die Verwendung elastisch-kompressibler Polymere als Formmasse für die Zwischenschicht. Dabei können elastischkompressible Polymere mit einer mikrozellularen Schaumstruktur als leicht verarbeitbare Formmasse verwendet werden. Eine problemlose spritzgießtechnische Verarbeitung ergibt sich jedoch auch dann, wenn für die Zwischenschicht elastischkompressible Polymere mit elastischen Mikrohohlkörpern als Füllstoff verwendet werden.

Gemäß einer weiteren bevorzugten Ausgestaltung der Erfindung wird beim Spritzgießen der Zwischenschicht die Hohlform des ersten Spritzgießwerkzeugs nicht vollständig gefüllt. Durch eine derartige verbleibende Volumenreserve beim Spritzgießen kann der Werkzeuginnendruck extrem niedrig bleiben, so daß sog. Drahtverwehungen und ähnliche Erscheinungen sicher vermieden werden können.

Weiterhin hat es sich als besonders vorteilhaft erwiesen, wenn die Zwischenschicht in Form einer einseitigen Abdeckung aufgebracht wird, wobei die gegenüberliegende Seite durch einen steuerbaren Werkzeugeinsatz des ersten Spritzgießwerkzeugs abgestützt wird. Der steuerbare Werkzeugeinsatz wirkt hierbei als Gegenlager der Systemträger-Insel oder dgl.. Insbesondere kann dann auch für das Aufbringen der Zwischenschicht in dem ersten Spritzgießwerkzeug und das Aufbringen der äußeren Umhüllungsschicht im zweiten Spritzgießwerkzeug dasselbe Werkzeug-Unterteil mit steuerbarem Werkzeugeinsatz verwendet werden. Der steuerbare Werkzeugeinsatz wirkt dann beim Aufbringen der Zwischenschicht als Gegenlager, während er beim Aufbringen der äußeren Umhüllung zurückgefahren wird und dadurch den erforderlichen Hohlraum im Werkzeug-Unterteil schafft.

Die Erfindung gibt auch eine Umhüllung für elektrische und elektronische Bauelemente oder Baugruppen mit einer auf die mechanisch empfindlichen Bereiche aufgebrachten Zwischenschicht aus einem elastischen Kunststoff und einer äußeren Umhüllungsschicht aus einem mechanisch und chemisch stabilen Kunststoff an, bei welcher die äußere Umhüllungsschicht aus einem spritzgegossenen Thermoplast besteht und somit besonders wirtschaftlich hergestellt werden kann. Diese Vorteile ergeben sich dann auch für die Zwischenschicht, wenn diese aus einem spritzgegossenen thermoplastischen Elastomer oder aus einem spritzgegossenen elastisch-kompressiblen Polymer besteht.

Ausführungsbeispiele der Erfindung sind in der Zeichnung dargestellt und werden im folgenden näher beschrieben.

Es zeigen:

Figur 1 das Aufbringen einer elastischen Zwischenschicht auf einen integrierten Schaltkreis durch Spritzgießen,

Figur 2 eine Draufsicht auf die gemäß Figur 1 hergestellte Zwischenschicht bei abgenommenem Werkzeug-Oberteil des Spritzgießwerkzeugs,

Figur 3 das Aufbringen einer äußeren Umhüllungsschicht auf den in den Figuren 1 und 2 dargestellten integrierten Schaltkreis mittels Spritzgießen,

Figur 4 das Aufbringen einer elastischen Zwischenschicht auf eine elektronische Baugruppe durch Spritzgießen und

Figur 5 das Aufbringen einer äußeren Umhüllungsschicht auf die in Figur 4 dargestellte elektronische Baugruppe mittels Spritzgießen.

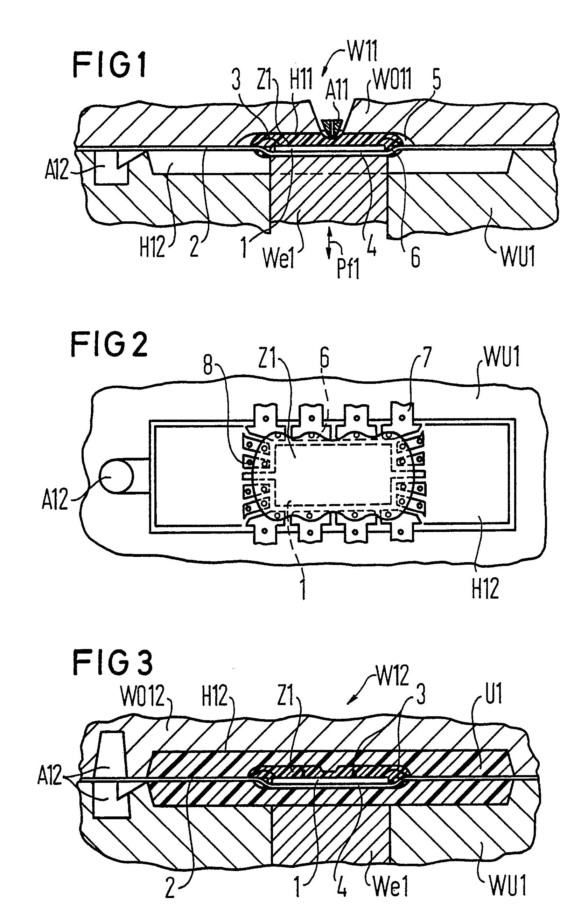

Die Figuren 1 bis 3 zeigen das zweistufige Umhüllen eines integrierten Schaltkreises. Der insgesamt als IC bezeichnete Baustein besteht aus einem Chip 1, der auf einem Systemträger 2 angeordnet ist und dessen Anschlüsse über feine Bonddrähte 3 mit den zugeordneten Anschlußbeinen des Systemträgers 2 verbunden sind. Aus dem in Figur 1 dargestellten Schnitt ist zu erkennen, daß die äußeren Bereiche des Systemträgers 2 dicht zwischen dem Werkzeug-Oberteil WO11 und dem Werkzeug-Unterteil WU1 eines ersten Spritzgießwerkzeugs W11 angeordnet werden, während der Chip 1 und die mechanisch empfindlichen Bereiche am Chip-Umfang mit den Kontaktstellen der Bonddrähte 3 sich innerhalb der Hohlform H11 des ersten Spritzgießwerkzeugs W11 befinden. Im Werkzeug-Unterteil WU1 befindet sich ein in Richtung des Doppelpfeiles Pf1 vertikal verfahrbarer steuerbarer Werkzeugeinsatz We1, der in seiner in Figur 1 dargestellten oberen Stellung als Gegenlager der Systemträger-Insel 4 wirkt. In dieser oberen Stellung des Werkzeugeinsatzes We1 wird dann über eine Angußbuchse A11 die Hohlform H11 mit einem thermoplastischen Elastomer gefüllt, wobei die Füllung jedoch nicht vollständig ist und eine gewisse Volumenreserve 5 verbleibt. Durch diese volumenreserve 5 kann der Werkzeuginnendruck beim Spritzgießen extrem niedrig bleiben, d.h. Verwehungen der Bonddrähte 3 werden mit Sicherheit vermieden.

Durch den vorstehend beschriebenen ersten Spritzgießvorgang wird eine elastische Zwischenschicht Z1 erzeugt, die gemäß der in Figur 2 bei abgenommenen Werkzeug-Oberteil WO11 dargestellten Draufsicht neben einer vollständigen Abdeckung des Chips 1 gleichzeitig die Chipränder 6 und sämtliche Bonddrähte 3 gänzlich bis über die sich auf den Anschlußbeinen 7 befindlichen Wedge-Kanten 8 hinaus umschließen. Bei den Wedge-Kanten 8 handelt es sich um Kontaktstellen, die beim sog. Wedgebonding der Bonddrähte 3 entstanden sind. Es ist leicht zu erkennen, daß durch die elastische Zwischenschicht Z1 die mechanisch empfindlichen Bereiche, insbesondere der Chip-Bereich und der angrenzende Anschluß-Bereich, geschützt werden.

Nach dem Aufbringen der Zwischenschicht Z1 wird gemäß Figur 3 der steuerbare Werkzeugeinsatz We1 in seine untere Stellung verfahren und das Werkzeug-Unterteil WU1 mit einem zweiten Werkzeug-Oberteil WO12 kombiniert, wodurch ein insgesamt W12 bezeichentes zweites Spritzgießwerkzeug entsteht. In die Hohlform H12 dieses zweiten Spritzgießwerkzeugs W12 wird dann über eine stirnseitige Anbindung A12 eine thermoplastische Formmasse hoher Festigkeit eingespritzt, welche eine äußere Umhüllungsschicht U1 bildet. Beim Spritzgießen dieser äußeren Umhüllungsschicht U1 wird auf die Zwischenschicht Z1 ein Druck ausgeübt, der ein elastisch haftendes dichtes Kissen erzeugt.

Bei dem vorstehend beschriebenen zweistufigen Umhüllen eines IC-Bausteins kann also für das Spritzgießen der Zwischenschicht Z1 and das Spritzgießen der äußeren Umhüllungsschicht U1 dasselbe Werkzeug-Unterteil WU1 verwendet werden, wobei diese doppelte Verwendung durch den steuerbaren Werkzeugeinsatz We1 ermöglicht wird.

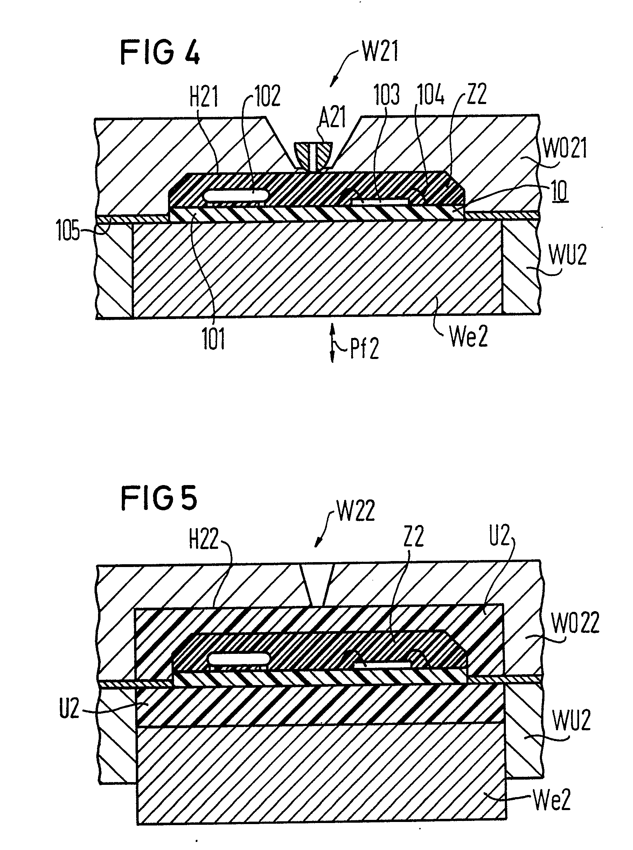

Die Figuren 4 und 5 zeigen das zweistufige Umhüllen einer Baugruppe 10, von welcher auf einem Substrat 101 angeordnete Bauelemente 102 und 103, Bonddrähte 104 und äußere Anschlüsse 105 zu erkennen sind. Diese Baugruppe 10 wird nun zunächst gemäß Figur 4 in ein erstes Spritzgießwerkzeug W21 eingebracht, in dessen Werkzeug-Oberteil WO21 sich eine der Fläche des Substrats 101 angepaßte Hohlform H21 befindet. Im Werkzeug-Unterteil WU2 befindet sich ein in Richtung des Doppelpfeiles Pf2 vertikal verfahrbarer steuerbarer Werkzeugeinsatz We2, der in seiner in Figur 4 dargestellten oberen Stellung das gesamte Substrat 101 von unten her abstützt. Die Hohlform H21 wird dann über eine Angußbuchse A21 mit einem thermoplastischen Elastomer gefüllt, welches den gesamten Substratbereich abdeckt und eine elastische Zwischenschicht Z2 bildet.

Nach dem geschilderten ersten Spritzgießvorgang zur Bildung der elastischen Zwischenschicht Z2 wird der steuerbare Werkzeugeinsatz We2 in seine in Figur 5 dargestllte untere Stellung verfahren und auf das Werkzeug-Unterteil WU2 ein zweites Werkzeug-Oberteil WO22 aufgesetzt. Hierdurch entsteht ein zweites Spritzgießwerkzeug W22 in dessen Hohlraum H22 zur Bildung einer äußeren Umhüllungsschicht U2 eine thermoplastische Formmasse hoher Festigkeit unter Druck eingespritzt wird.

Anstelle des in Figur 4 dargestellten Spritzgießens der elastischen Zwischenschicht Z2 könnte diese elastische oder elastisch-kompressible Schicht auch beispielsweise durch Gießen oder Aufdosieren appliziert werden.

Das anhand der Figuren 4 und 5 beschriebene Umhüllen der Baugruppe 10 kann auch für das Versiegeln einer in einem rahmenartigen Gehäusekörper vormontierten Baugruppe oder eines in einem Gehäuseunterteil vormontierten Bauteils angewandt werden.

Bei dem anhand den Figuren 1 bis 3 beschriebenen Umhüllen eines IC-Bausteins bzw. bei dem anhand der Figuren 4 und 5 beschriebenen Umhüllen einer Baugruppe 10 werden beim Spritzgießen der Zwischenschicht Z1 bzw. Z2 vorzugsweise thermoplastische Elastomere als Formmasse verwendet, wobei beispielsweise Elastomere auf Polyolefinbasis, Polyether, Polyurethane oder Polyetherester geeignet sind. Als in der praktischen Erprobung bewährte Formmassen können insbesondere Olefin-Dien-Terpolymere (Handelsname "Nordel" der Firma E.I. du Pont de Nemours & Co. Inc. Wilmington, Delaware US) und Polyetherester (Handelsname "Hytrel" der Firma E.I. du Pont de Nemours & Co. Inc. Wilmington, Delaware, US oder Handelsname „Arnitel" der Firma Akzo plastics bv, Zeist, Holland) genannt werden. Zur Erzielung elastisch-kompressibler Eigenschaften der Zwischenschichten Z1 bzw. Z2 können auch entsprechende spritzgießfähige elastisch-kompressible Polymermaterialien verwendet werden, die beispielsweise eine mikrozellulare Struktur oder elastische Mikrohohlkörper als Füllkörper besitzen. In die Formmasse können beispielsweise 10 bis 15 Vol.% Mikrohohlkörper aus Polyvinylidenchlorid (PVDC) mit einem mittleren Durchmesser von 40 $\mu$m und einer Wandstärke von ca. 0,5 $\mu$m (Produkt der Firma Follmann & Co.) eingemischt werden.

Für das Spritzgießen der äußeren Umhüllungsschichten U1 bzw. U2 werden vorzugsweise thermoplastische Formmassen, insbesondere teilkristalline oder flüssigkristalline Thermoplaste verwendet. Als Beispiel für teilkristalline Thermoplaste kann Polyphenylensulfid (PPS) genannt werden (Handelsname "Ryton" der Firma Phillips Petroleum Co., Bartlesville, US).

Polyphenylensulfid zeichnet sich durch eine sehr hohe Temperaturbelastbarkeit bis zu 260°C aus. Als Beispiele für äußere Umhüllungsschichten U1 bzw. U2 auf der Basis flüssigkristalliner Thermoplaste können eine unter dem Handelsnamen "Vectra" erhältliche Formmasse (Firma Celanese Corp. of America, New York, N.Y., US) und eine unter dem Handelsnamen "Ultrax" erhältliche Formmasse (BASF AG, Ludwigshafen, DE) genannt werden.

## Ansprüche

1. Verfahren zum Umhüllen von elektrischen und elektronischen Bauelementen oder Baugruppen, bei welchem zunächst auf die mechanisch empfindlichen Bereiche eine Zwischenschicht aus einem elastischen Kunststoff und dann eine äußere Umhüllungsschicht aus einem mechanisch und chemisch stabilen Kunststoff aufgebracht werden,
**dadurch gekennzeichnet,**
daß die äußere Umhüllungsschicht (U1; U2) in der Hohlform (H12; H22) eines Spritzgießwerkzeugs (W12; W22) durch Spritzgießen einer Formmasse aufgebracht wird.

2. Verfahren nach Anspruch 1,
**dadurch gekennzeichnet,**
daß für die äußere Umhüllungsschicht (U1; U2) eine thermoplastische Formmasse verwendet wird.

3. Verfahren nach Anspruch 2,
**dadurch gekennzeichnet,**
daß für die äußere Umhüllungsschicht (U1; U2) teilkristalline Thermoplaste als Formmasse verwendet werden.

4. Verfahren nach Anspruch 2,
**dadurch gekennzeichnet,**
daß für die äußere Umhüllungsschicht (U1; U2) flüssigkristalline Thermoplaste als Formmasse verwendet werden.

5. Verfahren nach einem der vorhergehenden Ansprüche, **dadurch gekennzeichnet,**
daß die Zwischenschicht (Z1; Z2) in der Hohlform (H11; H21) eines ersten Spritzgießwerkzeugs (W11; W21) durch Spritzgießen einer Formmasse aufgebracht wird.

6. Verfahren nach Anspruch 5,
**dadurch gekennzeichnet,**
daß für die Zwischenschicht (Z1; Z2) thermoplastische Elastomere als Formmasse verwendet werden.

7. Verfahren nach Anspruch 5 oder 6,
**dadurch gekennzeichnet,**

daß für die Zwischenschicht (Z1; Z2) elastisch-kompressible Polymere als Formmasse verwendet werden.

8. Verfahren nach Anspruch 7,
**dadurch gekennzeichnet,**
daß für die Zwischenschicht (Z1; Z2) elastisch-kompressible Polymere mit einer mikrozellularen Schaumstruktur als Formmasse verwendet werden.

9. Verfahren nach Anspruch 7,
**dadurch gekennzeichnet,**
daß für die Zwischenschicht (Z1; Z2) elastisch-kompressible Polymere mit elastischen Mikrohohlkörpern als Füllstoff verwendet werden.

10. Verfahren nach einem der Ansprüche 5 bis 9,
**dadurch gekennzeichnet,**
daß beim Spritzgießen der Zwischenschicht (Z1; Z2) die Hohlform (H11; H21) des ersten Spritzgießwerkzeugs (W11; W21) nicht vollständig gefüllt wird.

11. Verfahren nach einem der Ansprüche 5 bis 9,
**dadurch gekennzeichnet,**
daß die Zwischenschicht (Z1; Z2) in Form einer einseitigen Abdeckung aufgebracht wird, wobei die gegenüberliegende Seite durch einen steuerbaren Werkzeugeinsatz (We1; We2) des ersten Spritzgießwerkzeugs (W11; W21) abgestützt wird.

12. Verfahren nach Anspruch 11,
**dadurch gekennzeichnet,**
daß für das Aufbringen der Zwischenschicht (Z1; Z2) in dem ersten Spritzgießwerkzeug (W11; W21) und das Aufbringen der äußeren Umhüllungsschicht (U1; U2) im zweiten Spritzgießwerkzeug (W12; W22) dasselbe Werkzeug-Unterteil (WU1; WU2) mit steuerbarem Werkzeugeinsatz (We1; We2) verwendet wird.

13. Umhüllung für elektrische und elektronische Bauelemente oder Baugruppen mit einer auf die mechanisch empfindlichen Bereiche aufgebrachten Zwischenschicht aus einem elastischen Kunststoff und einer äußeren Umhüllungsschicht aus einem mechanisch und chemisch stabilen Kunststoff,
**dadurch gekennzeichnet,**
daß die äußere Umhüllungsschicht (U1; U2) aus einem spritzgegossenen Thermoplast besteht.

14. Umhüllung nach Anspruch 13,
**dadurch gekennzeichnet,**
daß die Zwischenschicht (Z1; Z2) aus einem spritzgegossenen thermoplastischen Elastomer besteht.

15. Umhüllung nach Anspruch 13 oder 14,
**dadurch gekennzeichnet,**
daß die Zwischenschicht (Z1; Z2) aus einem spritzgegossenen elastisch-kompressiblen Polymer besteht.

# FIG 1

# FIG 2

# FIG 3

## FIG 4

## FIG 5